# EUROPÄISCHE PATENTSCHRIFT

(11) **EP 3 322 834 B1**
(45) Veröffentlichungstag und Bekanntmachung des Hinweises auf die Patenterteilung: **28.08.2019**
(21) Anmeldenummer: 16738183.9
(22) Anmeldetag: 13.07.2016
(51) Int. Cl.: C23C 14/14, C23C 14/35, C23C 16/26, C23C 16/503

(54) **VERFAHREN ZUM ABSCHEIDEN EINER GRAPHENBASIERTEN SCHICHT AUF EINEM SUBSTRAT MITTELS PECVD**
METHOD FOR PECVD DEPOSITION OF A GRAPHENE-BASED LAYER ON A SUBSTRATE
PROCÉDÉ PERMETTANT DE DÉPOSER UNE COUCHE À BASE DE GRAPHÈNE SUR UN SUBSTRAT PAR DÉPÔT CHIMIQUE EN PHASE VAPEUR ASSISTÉ PAR PLASMA (PECVD)

(30) Priorität: 14.07.2015 DE 102015111351
(43) Veröffentlichungstag der Anmeldung: 23.05.2018
(73) Patentinhaber: Fraunhofer-Gesellschaft zur Förderung der angewandten Forschung e.V., 80686 München (DE)
(72) Erfinder: WALD, Katrin, 01189 Dresden (DE); FAHLAND, Matthias, 01257 Dresden (DE); GÜNTHER, Steffen, 01217 Dresden (DE); SCHILLER, Nicolas, 01833 Stolpen OT Helmsdorf (DE)
(86) Internationale Anmeldenummer: PCT/EP2016/066584
(87) Internationale Veröffentlichungsnummer: WO 2017/009359

(56) Entgegenhaltungen:
- US-A1- 2013 187 097
- HYUNGKI KIM ET AL: "Copper-Vapor-Assisted Chemical Vapor Deposition for High-Quality and Metal-Free Single-Layer Graphene on Amorphous SiO 2 Substrate", ACS NANO, Bd. 7, Nr. 8, 27. August 2013 (2013-08-27) , Seiten 6575-6582, XP055306142, US ISSN: 1936-0851, DOI: 10.1021/nn402847w

## Beschreibung

Die Erfindung betrifft ein Verfahren zum Abscheiden einer graphenbasierten Schicht auf einem Substrat mittels chemischer Gasphasenabscheidung (auch Chemical Vapor Deposition oder verkürzt CVD genannt). Dabei gelangt ein Plasma zum Unterstützen des CVD-Prozesses zum Einsatz, so dass das erfindungsgemäße Verfahren der Gattung der plasmaunterstützten chemischen Gasphasenabscheidung (auch Plasma Enhanced Chemical Vapor Depostion oder verkürzt PECVD genannt) zuzuordnen ist.

Graphen ist wie Diamant, Graphit und Kohlenstoffnanoröhren, eine Modifikation des Elements Kohlenstoff. Graphen als zweidimensionales, bienenwabenartiges Netzwerk sp²-hybridisierter Kohlenstoffatome ist der Grundbaustein von Graphit, der aus übereinandergestapelten Graphen-Schichten besteht. Interesse weckt Graphen aufgrund seiner außergewöhnlichen physikalischen Eigenschaften. Es ist mechanisch sehr stabil, weist eine sehr hohe Zugfestigkeit auf, leitet Wärme mehr als 10-fach besser als Kupfer, besitzt eine theoretische Ladungsträgerbeweglichkeit von bis zu 200000 cm²V⁻¹s⁻¹ und eine Monolage Graphen absorbiert nur 2,3 % des Lichts unabhängig von der Wellenlänge im sichtbaren Spektrum.

Aufgrund seiner Eigenschaften können Graphen-Schichten, neben vielen anderen potentiellen Anwendungen, als Alternative für TCO (transparent conductive oxide - transparent leitfähige Oxide), wie zum Beispiel ITO, als transparente leitfähige Schicht, wie beispielsweise zur Herstellung von Solarzellen aber auch bei OLED- und Display-Anwendungen eingesetzt werden, vor allem dann wenn Anforderungen hinsichtlich einer mechanischen Flexibilität bestehen.

Es ist eine Vielzahl von Verfahren bekannt, welche das Herstellen von Graphen ermöglichen. Graphen-Nanoplatelets und Graphenoxid-Flakes, das heißt Graphen-Partikel mit lateralen Ausdehnungen im nm- bis µm-Bereich, können über das sogenannte Abblättern (auch Exfoliation bezeichnet) von Graphit synthetisiert werden.

Graphen-Schichten lassen sich beispielsweise mittels einer thermischen Zersetzung auf Siliziumkarbid (SiC) herstellen. Dabei sind Prozesstemperaturen von über 1000 °C erforderlich, damit die Siliziumatome der obersten Schicht aufgrund des höheren Dampfdrucks abdampfen und sich die verbleibenden Kohlenstoffatome zu einer Graphen-Schicht formieren.

GB 2 331 998 A beschreibt Verfahren zum Abscheiden von Kohlenstoffschichten mit einem Graphen-Anteil, bei welchen ein Kohlenstofftarget mittels Magnetronsputtern zerstäubt wird. Bei Ausführungsformen dieser Verfahren kann auch noch mittels eines weiteren Magnetrons ein Target aus einem Übergansmetall zerstäubt und in die Kohlenstoffschicht eingelagert werden, was jedoch den Graphen-Anteil in der Kohlenstoffschicht weiter reduziert.

Bei einem anderen bekannten Verfahren werden Graphen-Schichten mittels chemischer Gasphasenabscheidung hergestellt, bei denen Kohlenwasserstoffe, wie zum Beispiel Methan, als Ausgangsmaterialien für eine Graphen-Abscheidung auf metallischen Substraten bei Temperaturen um 1000 °C verwendet werden. Zum Einsatz gelangen dabei Übergangsmetalle, wie beispielsweise Cu, Ni und Co, die im CVD-Prozess gleichzeitig als Katalysator und Substrat dienen und welche die erforderliche Zersetzungstemperatur des Kohlenwasserstoff-Präkursors senken.

Wesentliche Nachteile der bekannten Verfahren sind die hohen Substrattemperaturen um 1000 °C, die dabei erforderlichen metallischen Katalysatorsubstrate, die einen nachträglichen Transfer der Graphen-Schichten auf ein eigentliches Zielsubstrat zwingend notwendig machen, und die hohen Substratkosten im Fall des Verwendens von SiC-Wafern. Der Transferprozess ist technologisch aufwendig und erzeugt zusätzliche Defekte in der Graphen-Schicht.

Plasmaunterstützte CVD-Verfahren ermöglichen eine Absenkung der Substrattemperatur durch die plasma-induzierte Dissoziation des Kohlenwasserstoff-Präkursors, nutzen aber weiterhin katalytische Metallsubstrate mit anschließendem Transfer der Graphen-Schichten auf das gewünschte Zielsubstrat. Die Plasmaanregung erfolgt meist durch Mikrowellen mit einer Frequenz von 2,45 GHz (WO 2013/052939 A1, WO 2013/052939 A1) oder durch eine Hochfrequenz-Anregung mit einer Frequenz von 13,56 MHz (WO 2014/137985 A1).

Des Weiteren sind Verfahren der plasmaunterstützten chemischen Schichtabscheidung bekannt, bei welchen ein Plasma induktiv eingekoppelt wird (US 2013/0187097 A1). Hierbei wird der Schichtabscheideprozess unterstützt, indem ein katalytisch wirksames Material vor der Graphenschichtabscheidung auf einem zu beschichtenden Substrat aufgetragen wird.

Hyungki Kim ET AL: "Copper-Vapor-Assisted Chemical Vapor Deposition for High-Quality and Metal-Free Single-Layer Graphene on Amorphous SiO2 Substrate, ACS Nano, Bd. 7, Nr. 8, 2013, Seiten 6575 - 6582 beschreibt eine weitere Ausgestaltungsform der chemischen Schichtabscheidung, bei welcher ein Katalysator in Form einer Kupferfolie in eine Arbeitskammer eingebracht wird, die während des Schichtabscheideprozesses sublimiert.

Die gänzlich katalysatorfreie Abscheidung von Graphen-Schichten direkt auf den Zielsubstraten ohne aufwendige Transferprozesse ist bereits bekannt, allerdings konnten bisher nur nanokristalline Graphen-Schichten abgeschieden werden, deren Qualität gegenüber der Abscheidung mit Katalysator deutlich reduziert ist. Die erreichbaren Schichtwiderstände liegen deutlich über denen von auf metallischen Katalysatorsubstraten mittels CVD abgeschiedenen Graphen-Schichten.

Aus DE 34 42 208 A1 sind Verfahren zum Herstellen harter Kohlenstoffschichten bekannt, bei denen eine gasförmige Kohlenwasserstoffverbindung in einer ionisierten Gasatmosphäre mittels eines Magnetronplasmas zersetzt wird. Dabei ist das Magnetron mit einem Target aus mindestens einem der Metalle Tantal, Titan, Chrom und Wolfram bestückt, wobei zunächst eine reine Schicht aus dem Targetmaterial als Haftvermittler auf einem Substrat abgeschieden wird und anschließend die eigentliche Kohlenstoffschicht. Eine derart abgeschiedene Kohlenstoffschicht kann auch Anteile von Graphit aufweisen.

Ferner wurde auch der Ansatz untersucht, einen metallischen Katalysator nicht als Substrat sondern anderweitig in einen CVD-Prozess einzubringen [J. Teng et al, Remote Catalyzation for direct formation of graphene layers on oxides, Nano Letters 12 (2012) 1379-1384; H. Kim et al, Copper-vapor-assisted chemical vapor deposition for high-quality and metal free single-layer graphene on amorphous SiO2 substrates, ACS Nano 7 (2013) 6575-658]. Die hierbei nach wie vor erforderlichen hohen Substrattemperaturen von 1000°C und das zusätzliche Einbringen des metallischen Katalysators begrenzen aber weiterhin die Substratvielfalt und damit einhergehend die Anwendungsbreite sowie die industrielle Durchsetzung der auf diese Weise abgeschiedenen Graphen-Schichten.Allen bisher bekannten Verfahren haften somit die Nachteile an, dass mit diesen keine großflächigen Graphen-Schichten abgeschieden werden können, dass diese eine hohe Prozesstemperatur erfordern, sehr energie- und kostenintensiv oder an metallische Katalysatorsubstrate gebunden sind, die zusätzliche Prozessschritte zum Transfer der Graphen-Schichten benötigen.

### Aufgabenstellung

Der Erfindung liegt die Aufgabe zugrunde, ein Verfahren für das Abscheiden von graphenbasierten Schichten zu schaffen, mittels dessen die Nachteile aus dem Stand der Technik überwunden werden. Insbesondere sollen mit dem erfindungsgemäßen Verfahren graphenbasierte Schichten großflächig und integrierbar in bestehende Fertigungsprozesse, energie- und kostengünstig sowie auf vielfältigen, insbesondere katalysatorfreien Substraten bei gleichzeitig hoher Qualität abgeschieden werden können.

Diese Aufgabe wird erfindungsgemäß gelöst durch ein Verfahren zum Herstellen einer graphenbasierten Schicht mit den Merkmalen des Anspruchs 1. Weitere vorteilhafte Ausgestaltungen der Erfindung ergeben sich aus den abhängigen Ansprüchen. Als graphenbasierte Schicht im Erfindungssinn sind Kolenstoff-Schichten zu verstehen, die Graphen enthalten, wobei das Enthalten auch beinhalten soll, dass die Schicht vollständig aus Graphen besteht.

Beim erfindungsgemäßen Verfahren wird eine graphenbasierte Schicht mittels chemischer Gasphasenabscheidung auf einem Substrat innerhalb einer Vakuumkammer abgeschieden. Dabei wird zumindest ein Kohlenwasserstoff als Ausgangsmaterial für eine chemische Reaktion in die Vakuumkammer eingelassen und gleichzeitig ein Plasma innerhalb der Vakuumkammer ausgebildet. Das erfindungsgemäße Verfahren zeichnet sich ferner dadurch aus, dass mindestens ein Magnetron zum Erzeugen des Plasmas verwendet wird, wobei das Magnetron mindestens ein Target umfasst, dessen Material mindestens ein Metall aus der Gruppe der chemischen Elemente mit den Ordnungszahlen 21 bis 30, 39 bis 48, 57, 72 bis 80 und 89 enthält.

Metallene Elemente mit den Ordnungszahlen 21 bis 30, 39 bis 48, 57, 72 bis 80 und 89 sind gute Katalysatoren für eine Vielzahl von Reaktionen, deren katalytische Wirkung sich aus den unvollständig gefüllten d-Atomorbitalen und/oder der Bildung von Zwischenverbindungen, welche die Reaktivität von Präkursoren begünstigen, ergibt. Die chemischen Elemente mit den Ordnungszahlen 21 bis 30, 39 bis 48, 57, 72 bis 80 und 89 werden daher nachfolgend bezüglich des erfindungsgemäßen Verfahrens auch als katalytisch wirksame Metalle bezeichnet. Bei den Metallen Co, Ni, Cu, Ru, Pd, Ir und Pt wurde deren katalytische Wirksamkeit bei der Abscheidung von Graphen bereits in Laborversuchen nachgewiesen. Besonders geeignet als katalytisch wirksames Targetmaterial ist das Element Cu, weil dieses relativ preiswert in der Anschaffung und technisch einfach handhabbar ist.

Beim Verwenden mindestens eines katalytisch wirksamen Metalls als Targetmaterial eines Magnetrons werden zwei Vorteile in einem technischen Merkmal vereint. Zum einen dient das Magnetron zum Erzeugen eines Plasmas, mit dem ein Kohlenwasserstoff aufgespalten und die aufgespaltenen Bestandteile zur chemischen Schichtabscheidung angeregt werden, zum anderen fungiert das Targetmaterial des Magnetrons katalytisch dahingehend, dass der abgeschiedene Kohlenstoff als Graphen ausgebildet wird. Mit dem erfindungsgemäßen Verfahren können daher auch Substrate mit Graphen beschichtet werden, die im abzuscheidenden Oberflächenbereich kein katalytisch wirksames Metall aufweisen. Außerdem können mit dem erfindungsgemäßen Verfahren auch so große Substratflächen mit Graphen beschichtet werden wie sie aus dem Stand der Technik von Magnetron-PECVD-Verfahren zum Beschichten von Substraten mit anderen Schichtmaterialien bekannt sind.

Ein weiterer Vorteil des erfindungsgemäßen Verfahrens besteht darin, dass dieses auch bei Prozesstemperaturen unterhalb von 900 °C durchgeführt werden kann. Bei Laborversuchen war es sogar möglich, graphenbasierte Schichten bei Prozesstemperaturen unterhalb von 500 °C auszubilden. Gegenüber dem Stand der Technik kann dadurch eine größere Substratvielfalt mit Graphen beschichtet werden.

Als Ausgangsstoffe für die chemische Gasphasenabscheidung des erfindungsgemäßen Verfahrens sind alle Kohlenwasserstoffe geeignet, die auch bei bekannten CVD-Verfahren zum Abscheiden von Graphen verwendet werden, wie zum Beispiel Methan oder/und Acetylen.

Für das Ausbilden eines Magnetronplasmas innerhalb einer Vakuumkammer ist es erforderlich, auch noch ein Arbeitsgas in die Vakuumkammer einzulassen. Hierfür werden bei bekannten Verfahren oftmals Inertgase und bevorzugt Argon verwendet, um einen möglichst hohen Sputterabtrag am Magnetron-Target zu erzielen. Beim erfindungsgemäßen Verfahren wird es jedoch angestrebt eine möglichst reine Graphen-Schicht abzuscheiden. Das erfindungsgemäße Verfahren zeichnet sich dadurch aus, möglichst keine Targetpartikel oberhalb, unterhalb oder innerhalb einer herzustellenden graphenbasierten Schicht abzuscheiden. Das Targetmaterial dient beim erfindungsgemäßen Verfahren lediglich als Katalysator, damit der abgeschiedene Kohlenstoff als Graphen ausgebildet wird. Da es beim Betreiben eines Magnetrons meist nicht vollständig verhindert werden kann, dass Partikel vom Magnetrontarget abgestäubt und in der abgeschiedenen Schicht eingelagert werden, ist beim erfindungsgemäßen Verfahren das Abstäuben des Targets infolge des Magnetronsputterns derart einzustellen, dass der Anteil in der graphenbasierten Schicht eingelagerter Targetpartikel zumindest kleiner als 1 at% beträgt. Mit einem solchen Reinheitsgrad kann die abgeschiedene graphenbasierte Schicht schon bei einer Vielzahl von Anwendungsfällen eingesetzt werden. Es sei angemerkt, dass beim erfindungsgemäßen Verfahren auch kein Sputterabtrag am Target angestrebt wird, um Targetpartikel oberhalb oder unterhalb der graphenbasierten Schicht abzuscheiden.

Bei einer Ausführungsform des erfindungsgemäßen Verfahrens wird das Abstäuben des Targets infolge des Magnetronsputterns derart eingestellt, dass der Anteil in der graphenbasierten Schicht eingelagerter Targetpartikel kleiner als 0,1 at% beträgt.

Verfahrensschritte zum Einstellen eines Magnetronprozesses dahingehend, dass möglichst wenige Targetpartikel in die abgeschiedene Schicht eingelagert werden, sind bekannt. So kann zum Beispiel die elektrische Leistung eines Magnetrons so lange reduziert und somit auch der Sputterabtrag reduziert werden, bis der Anteil in der Schicht eingelagerter Targetpartikel einen erforderlichen Wert erreicht hat.

Zum Reduzieren des Sputterabtrages und somit auch zum Reduzieren des Eintrags von Targetpartikeln in die abgeschiedene Graphen-Schicht wird bei einer weiteren Ausführungsform neben dem Inertgas Argon ein weiteres Inertgas in die Vakuumkammer eingelassen. Besonders geeignet hierfür ist das Inertgas Helium, welches beim Argon-Helium-Gasgemisch innerhalb der Vakuumkammer einen Anteil von mindestens 60 % aufweist. Ein sehr geringer Sputterabtrag am Magnetrontarget wird erzielt, wenn das Helium beim Argon-Helium-Gasgemisch innerhalb der Vakuumkammer einen Anteil von mindestens 90 % aufweist.

### Ausführungsbeispiel

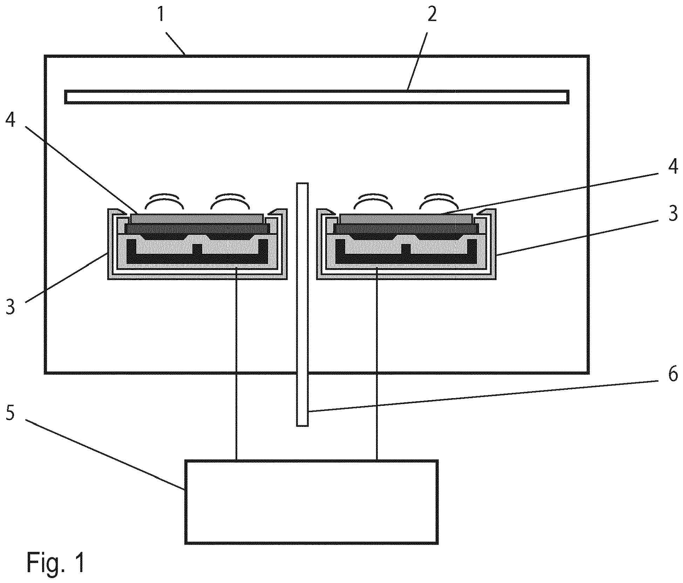

Die vorliegende Erfindung wird nachfolgend anhand eines Ausführungsbeispiels näher erläutert. Fig. 1 zeigt eine schematische Darstellung einer Beschichtungseinrichtung, die zum Ausführen des erfindungsgemäßen Verfahrens geeignet ist.

Die Beschichtungseinrichtung umfasst eine Vakuumkammer 1, innerhalb der eine graphenbasierte Schicht auf einem Substrat 2 abgeschieden werden soll. Das Substrat 2 ist als Siliziumwafer mit einer darauf bereits abgeschiedenen Siliziumoxidschicht ausgebildet, wobei die graphenbasierte Schicht auf der Siliziumoxidschicht abgeschieden werden soll. Vor dem Einbringen des Substrates 2 in die Vakuumkammer 1 wurde zumindest die zu beschichtende Oberfläche des Substrates 2 einem Reinigungs- und Trocknungsprozess unterzogen.

Innerhalb der Vakuumkammer 1 befindet sich ferner ein Doppelmagnetron, mittels dem ein Magnetronplasma ausgebildet wird. Das Doppelmagnetron umfasst zwei, sich in die Tiefe der Fig. 1 erstreckende planare Magnetrons 3, die jeweils mit einem Kupfertarget 4 bestückt sind. Mittels einer bipolar pulsenden Stromversorgung 5 werden die Magnetrons 3 abwechselnd und gegenläufig als Kathode bzw. Anode einer Magnetronentladung geschaltet. Die bipolar pulsende Stromversorgung 5 wird üblicherweise mit einer Frequenz im Bereich von 10 kHz bis 100 kHz betrieben.

Als Ausgangsstoff für die chemische Gasphasenabscheidung einer graphenbasierten Schicht auf dem Substrat 2 wird Methan durch einen Einlass 6 in die Vakuumkammer 1 eingelassen. Durch das Einwirken des mittels der Magnetrons 3 erzeugten Plasmas wird das Methan in der Vakuumkammer aufgespalten und aktiviert, infolgedessen eine kohlenstoffhaltige Schicht auf dem Substrat 2 abgeschieden wird. Bei der Schichtabscheidung wirken die Kupfertargets 4 gleichzeitig als Katalysator dahingehend, dass die abgeschiedenen Kohlenstoffpartikel als Graphen ausgebildet werden.

Für das Betreiben der Magnetrons 3 wird zusätzlich auch noch ein Arbeitsgas durch den Einlass 6 in die Vakuumkammer eingelassen, wobei das Arbeitsgas als Gasgemisch bestehend aus 95 % Helium und 5 % Argon ausgebildet wird. Der hohe Heliumanteil im Arbeitsgas führt zu einem vernachlässigbaren Sputterabtrag an den Magnetron-Targets 4, so dass auf dem Substrat 2 eine graphenbasierte Schicht mit hohem Reinheitsgrad abgeschieden wird. Bei der abgeschiedenen graphenbasierten Schicht wurde ein Kupferanteil von kleiner als 0,1 at% ermittelt. Mittels Raman-Spektroskopie konnte bei der abgeschiedenen Schicht das Ausbilden von Graphen nachgewiesen werden. Hierbei wurde im Vergleich zu einer Analyse einer Graphit-Schicht ein deutlich erhöhter 2D-Peak bei gleichzeitig reduzierten G-Peak ermittelt.

Bei der zuvor beschriebenen erfindungsgemäßen Schichtabscheidung wurde lediglich beispielhaft ein Doppelmagnetron, bestehend aus zwei planaren Magnetrons, verwendet.

Alternativ kann das erfindungsgemäße Verfahren auch mit jeder anderen Anzahl von Magnetrons durchgeführt werden, bei dem auch Magnetrons einer beliebigen anderen Bauform zur Anwendung gelangen können. Auch ist das erfindungsgemäße Verfahren sowohl für das stationäre als auch das dynamische Beschichten von Substraten geeignet.

Da der Begriff Magnetron auch für Einrichtungen zum Erzeugen von Mikrowellen verwendet wird, sei an dieser Stelle darauf verwiesen, das ein am erfindungsgemäßen Verfahren beteiligtes Magnetron immer als sogenanntes Sputter-Magnetron ausgebildet ist, mittels dem üblicherweise ein Sputterabtrag an einem zugehörigen Target angestrebt wird.

## Patentansprüche

1. Verfahren zum Abscheiden einer graphenbasierten Schicht auf einem Substrat mittels chemischer Gasphasenabscheidung, bei der zumindest ein Kohlenwasserstoff als Ausgangsmaterial für eine chemische Reaktion in eine Vakuumkammer eingelassen und gleichzeitig ein Plasma innerhalb der Vakuumkammer ausgebildet werden, **dadurch gekennzeichnet, dass** mindestens ein Magnetron zum Erzeugen des Plasmas verwendet wird, wobei das Magnetron mindestens ein Target umfasst, dessen Material aus mindestens einem katalytisch wirksamen Metall aus der Gruppe der chemischen Elemente Co, Ni, Cu, Ru, Pd, Ir, Pt ausgewählt wird und wobei die elektrische Leistung des Magnetrons derart eingestellt wird, dass der Anteil in der graphenbasierten Schicht eingelagerter Targetpartikel kleiner als 1 at% ist.

2. Verfahren nach Anspruch 1, **dadurch gekennzeichnet, dass** Methan oder/und Acetylen als Kohlenwasserstoff in die Vakuumkammer eingelassen wird.

3. Verfahren nach Anspruch 1, **dadurch gekennzeichnet, dass** ein Substrat verwendet wird, das im zu beschichtenden Oberflächenbereich kein katalytisch wirksames Metall aufweist.

4. Verfahren nach Anspruch 1, **dadurch gekennzeichnet, dass** ein kupferhaltiges Target für das Magnetron verwendet wird.

5. Verfahren nach Anspruch 1, **dadurch gekennzeichnet, dass** eine Prozesstemperatur gewählt wird, die kleiner als 900 °C ist.

6. Verfahren nach Anspruch 5, **dadurch gekennzeichnet, dass** eine Prozesstemperatur gewählt wird, die kleiner als 500 °C ist.

7. Verfahren nach Anspruch 1, **dadurch gekennzeichnet, dass** mindestens ein Inertgas in die Vakuumkammer eingelassen wird.

8. Verfahren nach Anspruch 7, **dadurch gekennzeichnet, dass** in die Vakuumkammer ein Argon-Helium-Gasgemisch mit einem Heliumanteil von mindestens 60 % eingelassen wird.

9. Verfahren nach einen der vorhergehenden Ansprüche, **dadurch gekennzeichnet, dass** das Sputtern des Targets derart eingestellt wird, dass der Anteil in der graphenbasierten Schicht eingelagerter Targetpartikel kleiner als 1 at% ist.

## Claims

1. Method of depositing a graphene-based layer on a substrate by means of chemical gas phase deposition, in which at least one hydrocarbon as starting material for a chemical reaction is admitted into a vacuum chamber and a plasma is simultaneously formed within the vacuum chamber, **characterized in that** at least one magnetron is used to produce the plasma, where the magnetron comprises at least one target, the material of which is selected from at least one catalytically active metal from the group of the chemical elements Co, Ni, Cu, Ru, Pd, Ir, Pt, and where the electrical power of the magnetron is adjusted such that the proportion in the graphene-based layer of intercalated target particles is less than 1 at%.

2. Method according to Claim 1, **characterized in that** methane or/and acetylene is admitted into the vacuum chamber as hydrocarbon.

3. Method according to Claim 1, **characterized in that** a substrate that does not include any catalytically active metal in the surface region to be coated is used.

4. Method according to Claim 1, **characterized in that** a copper-containing target is used for the magnetron.

5. Method according to Claim 1, **characterized in that** a process temperature less than 900°C is chosen.

6. Method according to Claim 5, **characterized in that** a process temperature less than 500°C is chosen.

7. Method according to Claim 1, **characterized in that** at least one inert gas is admitted into the vacuum chamber.

8. Method according to Claim 7, **characterized in that** an argon/helium gas mixture with a helium content of at least 60% is admitted into the vacuum chamber.

9. Method according to any of the preceding claims, **characterized in that** the sputtering of the target is adjusted such that the proportion in the graphene-based layer of intercalated target particles is less than 1 at%.

## Revendications

1. Procédé de dépôt d'une couche à base de graphène sur un substrat par dépôt chimique en phase vapeur, selon lequel au moins un hydrocarbure est introduit dans une chambre sous vide en tant que matière première pour une réaction chimique, et un plasma est simultanément formé dans la chambre sous vide, **caractérisé en ce qu**'au moins un magnétron est utilisé pour la formation du plasma, le magnétron comprenant au moins une cible dont le matériau est choisi parmi au moins un métal à activité catalytique du groupe des éléments chimiques Co, Ni, Cu, Ru, Pd, Ir, Pt, et la puissance électrique du magnétron étant ajustée de telle sorte que la proportion de particules de la cible incorporées dans la couche à base de graphène soit inférieure à 1 % atomique.

2. Procédé selon la revendication 1, **caractérisé en ce que** du méthane et/ou de l'acétylène sont introduits dans la chambre sous vide en tant qu'hydrocarbure.

3. Procédé selon la revendication 1, **caractérisé en ce qu**'un substrat qui ne comprend pas de métal à activité catalytique dans la zone de surface à revêtir est utilisé.

4. Procédé selon la revendication 1, **caractérisé en ce qu**'une cible contenant du cuivre est utilisée pour le magnétron.

5. Procédé selon la revendication 1, **caractérisé** en **ce qu**'une température de procédé qui est inférieure à 900 °C est choisie.

6. Procédé selon la revendication 5, **caractérisé** en **ce qu**'une température de procédé qui est inférieure à 500 °C est choisie.

7. Procédé selon la revendication 1, **caractérisé** en **ce qu**'au moins un gaz inerte est introduit dans la chambre sous vide.

8. Procédé selon la revendication 7, **caractérisé** en **ce qu**'un mélange gazeux d'argon et d'hélium ayant une proportion d'hélium d'au moins 60 % est introduit dans la chambre sous vide.

9. Procédé selon l'une quelconque des revendications précédentes, **caractérisé en ce que** la pulvérisation de la cible est ajustée de telle sorte que la proportion de particules de la cible incorporées dans la couche à base de graphène soit inférieure à 1 % atomique.
